# EUROPEAN PATENT APPLICATION

(11) **EP 1 480 263 A1**
(43) Date of publication of application: **24.11.2004**
(21) Application number: 03734895.0
(22) Date of filing: 30.01.2003
(51) Int. Cl.: H01L 21/304

(54) **METHOD OF TREATING SURFACE, SEMICONDUCTOR DEVICE, PROCESS FOR PRODUCING SEMICONDUCTOR DEVICE, AND APPARATUS FOR TREATMENT**

(30) Priority: 30.01.2002 JP 2002021097
(71) Applicant: Sony Corporation, Tokyo 141-0001 (JP)
(72) Inventor: SAGA, Koichiro, c/o SONY CORPORATION, Shinagawa-ku, Tokyo 141-0001 (JP)
(74) Representative: Land, Addick Adrianus Gosling
(86) International application number: PCT/JP2003/000938
(87) International publication number: WO 2003/065434

(57) **Abstract**

A surface treatment method of treating a surface having structural bodies formed thereon using a supercritical fluid (4) is characterized in adding a co-solvent or a reactant (5) such as ammonium hydroxide, alkanolamine, amine fluoride, hydrofluoric acid and so forth to the supercritical fluid (4) . The supercritical fluid (4) may also be added with a surfactant (6) together with the co-solvent or the reactant (5). It is allowable to use a polar solvent as the surfactant (6).

This makes it possible to provide a surface treatment method capable of thoroughly removing the residue only by a treatment using the supercritical fluid.

## Description

### TECHNICAL FIELD

The present invention relates to a surface treatment method, and in particular to a surface treatment method applicable to cleaning of a surface having, formed thereon, fine structural bodies with hollow portions or structural bodies such as high-aspect-ratio electrode patterns in fabrication of semiconductor device, micromachine and so forth. The present invention further relates to a semiconductor device obtained by the above-described surface treatment method, further to a method of fabricating a semiconductor device in which the surface treatment is involved, and still further to a treatment apparatus for practicing the surface treatment method. The present invention relates to a Japanese Patent Application shown below. For any designated states where incorporation of literatures by reference is approved, the contents described in the application below will be incorporated into the present invention so as to be granted as a part of the description of the present invention.

Japanese Patent Application No. 2002-021097, filed on January 30, 2002.

### BACKGROUND ART

In recent years, trends in scale-up of semiconductor devices have promoted micronization of the device structure, and LSI fabrication has reached a situation in which a high-aspect-ratio (height/width) pattern having a line width of even less than 100 nm is formed on a substrate. This sort of pattern is formed by subjecting a material film formed on the substrate to pattern etching. The pattern etching is typically proceeded under masking by a resist pattern, where also the aspect ratio of the resist pattern inevitably increases with increase in the aspect ratio of a pattern to be formed.

By the way, in this sort of pattern formation process, it is a general practice to subject the surface of the substrate to a series of aqueous cleaning, such as cleaning using a chemical solution and rinsing, and to drying process, for the purpose of removing fine foreign matters (etching residue) remained between the patterns after the pattern etching or the succeeding removal of the resist pattern. Also in formation process of the resist pattern, the aqueous cleaning and drying process are similarly carried out after the resist pattern is formed by development.

The cleaning of the fine pattern may, however, raise a problem in that the resist pattern may collapse during the drying process due to pressure difference between a rinsing solution remained between the patterns and the external air. The phenomenon relates to a process in which a rinsing liquid and a drying solution and so forth used for the drying are finally vaporized in the drying process, and is caused by reduction in volume of rinsing liquid or the drying solution due to the vaporization of the liquid remained between the high-aspect-ratio resist patterns, and consequent generation of capillary force by the liquid between the resist patterns. The capillary force depends on surface tension generated at gas-liquid interface between the patterns, and becomes more distinct between higher-aspect-ratio patterns. What is worse, the capillary force not only collapses the resist pattern, but may also deform other patterns composed of silicon or the like. This problem of surface tension caused by the rinsing solution becomes important.

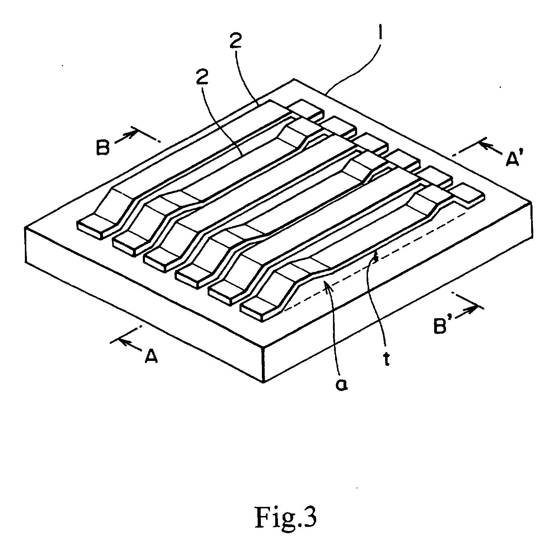

This problem may arise not only in fabrication process of semiconductor devices, but also in formation of a fine movable element called micro electromechanical systems (MEMS) . For example, micro electromechanical systems shown in Fig. 3 has a hollow portion "a" between a substrate 1 and a structural body 2 formed over it, and is configured as a movable element having a freely-adj ustable distance "t" between the structural body 2 and substrate 1. Thus-composed micro electromechanical systems can be formed by patterning a sacrificial layer, although not shown in the drawing, on the substrate 1, by patterning thereon the structural body 2, and by selectively etching the sacrificial layer off while leaving the substrate 1 and structural body 2.

It is therefore preferable, similarly to the above-described fabrication process of semiconductor devices, to subject the surface of the substrate to cleaning with a chemical solution, rinsing (washing with water) and drying in order to remove fine foreign matters (etching residue) remained between the patterns of the structural body 2. Adoption of aqueous cleaning and drying, such as those generally used for semiconductor manufacturing processes, to the cleaning after the hollow portion "a" is formed by selectively etching the sacrificial layer for removal, however, has raised a problem in that the structural body 2 which should be disposed as being spaced from the substrate 1 by the hollow portion "a" is undesirably stuck to the substrate 1 due to the above-described capillary, or is destroyed.

Hence, after the etching for forming this sort of hollow portion "a" in the fabrication process of micro electromechanical systems, it has been an only choice to skip the cleaning process and to send the work to the next process step. This, however, results in degradation in the yield ratio, reliability and element (movable element) characteristics due to the etching residue.

To solve the above-described problems, it is supposed to be desirable to use a fluid having a small surface tension for cleaning and drying. For example, water has a surface tension of approximately 72 dyn/cm, whereas methanol has a surface tension of approximately 23 dyn/cm, and this indicates that drying from methanol after being replaced from water is more successful than the drying from water in reducing the aforementioned capillary force possibly generated between the patterns or space portion, and in suppressing destruction of the patterns (structures). It is, however, still difficult to completely prevent the aforementioned destruction even if methanol is used as a drying liquid, because liquid methanol has a certain level of surface tension.

Hence, there has been proposed a method of using supercritical fluid in the surface treatment for cleaning the surface of the substrate such as having, formed thereon, the aforementioned high-aspect-ratio patterns or fine structural bodies having hollow portions. Supercritical fluid refers to one of phases possibly exhibited by various substances under temperature and pressure equal to or higher than the critical temperature and critical pressure which are specific to the individual substances, and is characterized by its unique properties such as having an extremely small viscosity and an extremely large diffusion coefficient despite the solubilization power with respect to other liquids and solids remains almost equivalent to that of the substance in liquid state, so that it can be said as a liquid having a gaseous state.

The surface treatment using this sort of supercritical fluid can follow the procedures below. First, after completion of pattern etching, and as being directly coming out from the etching solution, or out from a succeeding cleaning solution, or out from a rinsing solution replacing the cleaning solution, and so that the surface to be treated is kept in any of these solutions, the solution is replaced with a liquid of a substance capable of having a form of supercritical fluid (referredtoassupercritical substance, hereinafter). Next, the liquid is directly converted into a supercritical fluid without going through the gas state, by adjusting the pressure and temperature of the system having the surface to be treated and the liquid kept therein, and is then brought into the gas state. This is successful in drying the patterns on the surface to be treated formed by etching, without exposing them to the gas-liquid interface, and in preventing the pattern collapse or crush of the hollow portion due to surface tension of the rinsing solution (see Japanese Laid-Open Patent Publication Nos. 2000-91180 and 9-139374).

As the supercritical substance available for the above-described surface treatment, various substances which are confirmed as being capable of having a form of supercritical fluid, such as carbon dioxide, nitrogen, ammonia, water, alcohols, low-molecular-weight aliphatic saturated hydrocarbons, benzene and diethyl ether, are available. Among others, carbon dioxide having a supercritical temperature of 31. 3°C as close as to room temperature, is one substance preferably used for the surface treatment by virtue of its easy handlability and avoidability of high temperature of the sample.

The surface treatment method using the supercritical fluid has, however, suffered from the problems below. That is, carbon dioxide which is generally used as a supercritical fluid shows, in the state of supercritical fluid, properties just like those of non-polar organic solvent. Carbon dioxide in the state of supercritical fluid state (referred to as supercritical carbon dioxide), therefore, shows selectivity in the co-solvent or reaction performance, and is capable of removing low-molecular-weight organic matters such as pre-exposure photoresist, but is not always effective in removing contaminants including polymerized organic matters such as etching residue, and inorganic-converted mixed compound, and oxide film.

The drying using supercritical carbon dioxide must, therefore, be preceded by the aqueous cleaning using a chemical solution, which is a well-proven process excellent in co-solvent or reaction performance and oxidative decomposition performance.

In this case, in order to avoid the destruction possibly caused by surface tension at the gas-liquid interface, it is necessary to transfer the work, after completion of the cleaning, from a chemical solution into a rinsing solution under normal pressure, without exposing it to any gas, and to replace the rinsing solution directly with the supercritical carbon dioxide without vaporizing the rinsing solution, and thismakes the processmore complicated (see Japanese Laid-Open Patent Publication No. 2001-165568).

Moreover, cleaning solution, such as water, used for the aqueous cleaning has a large surface tension, and is less likely to infuse itself into bottom of patterned grooves having a high aspect ratio, or into fine hollow portion. Hence, stirring effort in order to infuse the cleaning solution or rinsing solution into the fine space may undesirably destroy mechanically fragile fine patterns or structural body due to water pressure caused by the stirring or the like.

It is therefore objects of the present invention to provide a surface treatment method capable of completely removing residues remaining between structural bodies only through a treatment with a supercritical fluid, and is consequently capable of reducing the number of process steps and of certainly avoiding destruction of the structural bodies; a semiconductor device obtainable by the surface treatment method; a method of fabricating a semiconductor device involving the surface treatment method; and a treatment apparatus for carrying out the surface treatment method.

### DISCLOSURE OF THE INVENTION

The present invention aimed at accomplishing the aforementioned objects is a surface treatment method in which a surface having structural bodies formed thereon are treated with a supercritical fluid. The structural body herein means a fine structural body bonded to a solid support substrate as being partially spaced therefrom, or a fine structural body having a large aspect ratio, which is a ratio of height and width of the structural pattern, even having no portion spaced from the solid support substrate. The former is a fine drive component called micro electromechanical systems as described in the above, and the latter is a fine pattern of semiconductor device or a photomask for forming the pattern. The present invention relates to a method of cleaning and drying these fine structural bodies.

A first treatment method of the present invention is characterized in adding an ammonium hydroxide expressed by the formula (1) below as a co-solvent or a reactant to a supercritical fluid: 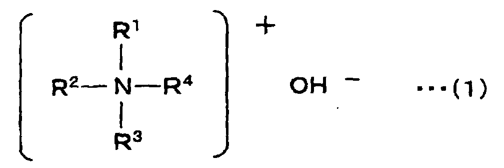 where, each of R¹ to R⁴ in the formula (1) independently denotes an alkyl group, hydroxy-substituted alkyl group, aryl group or hydrogen. The alkyl group and hydroxy-substituted alkyl group preferably has the number of carbon atoms of 1 to 4. The number of carbon atoms of this range can readily cause ionization in a solvent and dissociation of a hydroxyl group, and is successful in exhibiting a sufficient cleaning (etching) effect.

Specific examples of the ammonium hydroxide include ammonia, hydroxylamine, tetramethylammonium hydroxide, tetra ethylammonium hydroxide, tetrapropylammonium hydroxide, trimethylethylammonium hydroxide, benzyltrimethylammonium hydroxide, trimethyl(2-hydroxyethyl)ammonium hydroxide, triethyl(2-hydroxyethyl)ammonium hydroxide, tripropyl(2-hydroxyethyl)ammonium hydroxide, and trimethyl(1-hydroxypropyl)ammonium hydroxide. Of these, tetramethylammonium hydroxide (TMAH) and trimethyl (2-hydroxyethyl) ammonium hydroxide (also known as choline) are particularly preferable.

A second treatment method of the present invention is characterized in adding an alkanolamine expressed by the formula (2) below as a co-solvent or a reactant to the supercritical fluid:

R¹R²-N-CH₂ CH₂-O-R³ (2)

where, each of R¹ to R³ in formula (2) independently denotes an alkyl group, hydroxy-substituted alkyl group, aryl group or hydrogen. The alkyl group and hydroxy-substituted alkyl group preferably has the number of carbon atoms of 1 to 4. The number of carbon atoms of this range can readily produce a hydroxyl ion by accepting a proton (hydrogen ion) in the solvent, and is successful in exhibiting a sufficient cleaning (etching) effect.

Specific examples of the alkanolamine include monoethanolamine, diethanolamine, triethanolamine, tertiary-butyl diethanolamine, isopropanolamine, 2-amino-1-propanol, 3-amino-1-propanol, isobutanolamine, 2-amino-2-ethoxy-propanol, and 2-(2-aminoethoxy)ethanol also known as diglycolamine.

A third treatment method of the present invention is characterized in adding an amine fluoride expressed by the formula (3) below as a co-solvent or a reactant to a supercritical fluid: 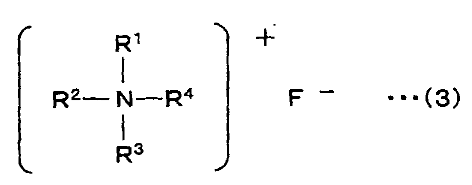 where, each of R¹ to R⁴ in the formula (3) independently denotes an alkyl group, hydroxy-substituted alkyl group, aryl group or hydrogen. The alkyl group and hydroxy-substituted alkyl group preferably has the number of carbon atoms of 1 to 4. The number of carbon atoms of this range can readily cause ionization in a solvent and dissociation of a fluorine ion, and is successful in exhibiting a sufficient cleaning (etching) effect.

Specific examples of the amine fluoride include ammonium fluoride, acidic ammonium fluoride, methylamine hydrofluoride, ethylamine hydrofluoride, propylamine hydrofluoride, tetramethylammonium fluoride, and tetraethylammonium fluoride. Of these fluorine compounds, ammonium fluoride and tetramethylammonium fluoride are preferable, and ammonium fluoride is more preferable.

A fourth treatment method of the present invention is characterized in adding hydrofluoric acid as a co-solvent or a reactant to the supercritical fluid. It is preferable herein to use hydrofluoric acid having a concentration of 0.1 to 1 mol/L.

In these first to fourth treatment methods, addition of the co-solvent or the reactant such as ammonium hydroxide, alkanolamine, amine fluoride or hydrofluoric acid to the supercritical fluid which is excellent in permeability makes it possible to supply the co-solvent or the reactant, together with the supercritical fluid, into the voids of fine structural bodies on the surface of the substrate. These co-solvents or reactants show a cleaning power capable of dissolving and removing (etching) the photoresist after etching and polymerized etching residue (simply referred to as residue, hereinafter). This results in an improved cleaning power of the supercritical fluid with respect to the surface of the substrate after the structural bodies are formed thereon by etching. Moreover, thus removed residue can readily be removed and washed away together with the chemical solution and supercritical fluid from the void between the structural bodies, because the supercritical fluid has a larger density than gas has. This consequently makes it possible to completely remove the residue in the voids of the fine structural bodies, without relying upon the aqueous cleaning. In particular for the case where hydrofluoric acid is used as the co-solvent or the reactant, this is also successful in obtaining an effect of removing oxides. It is to be noted that the co-solvent or the reactant described in the aforementioned first to fourth treatment methods may be added in plural number of species to the supercritical fluid.

In the aforementioned first to fourth treatment methods, carbon dioxide which can become a supercritical fluid at around normal temperature is preferably used as the supercritical fluid. It is, however, to be understood that the present invention is not only applicable to the case where the supercritical fluid composed of carbon dioxide is used, but also to the case where some non-polar supercritical fluid is used. Examples of this type of supercritical fluid include toluene, low-molecular-weight aliphatic saturated hydrocarbon, and benzene.

In the first to fourth treatment methods, the supercritical fluid is further addedwith a surfactant material, together with the aforementioned co-solvent or reactant.

Specific examples of the surfactant added to the supercritical fluid include salts of saturated fatty acids and unsaturated fatty acids having 12 to 20 carbon atoms, and more specifically include lauric acid, myristic acid, palmitic acid, stearic acid, oleic acid, linolic acid and linolenic acid. Another examples include aromatic salts such as dodecylbenzenesulfonic acid, alkyl dimethyl benzyl ammonium salt and nonylphenol polyoxyethylene ether; and phosphonic acid salts.

Polar solvent having both of hydrophilic group and hydrophobic group can be used as a compatibilization agent (surfactant). Specific examples thereof include alcohols such as methanol, ethanol, isopropanol, ethylene glycol and glycerin; ketones such as acetone, methyl ethyl ketone and methyl isopropyl ketone; alicyclic amine such as N-methylpyrrolidine; lactones such as γ-butyrolactone; esters such as methyl lactate and ethyl lactate; nitriles such as acetonitrile; ethers such as ethylene glycol monomethyl ether, ethylene glycol monoethyl ether, diethylene glycol, diethylene glycol monomethyl ether, diethylene glycol monoethyl ether, triethylene glycol monomethyl ether, diethylene glycol dimethyl ether and dipropylene glycol dimethyl ether; sulfones such as sulfolane; and sulfoxides such as dimethylsulfoxide. Among others, diethylene glycol monomethyl ether, diethylene glycol monoethyl ether, dipropylene glycol monomethyl ether, N-methylpyrrolidine, and dimethylsulfoxide are preferably used.

Use of this type of polar solvent successfully raises the cleaning (etching) effect through ionization of the polar solvent.

The above-described surfactant materials are used in a singular manner or as a mixture of two or more species.

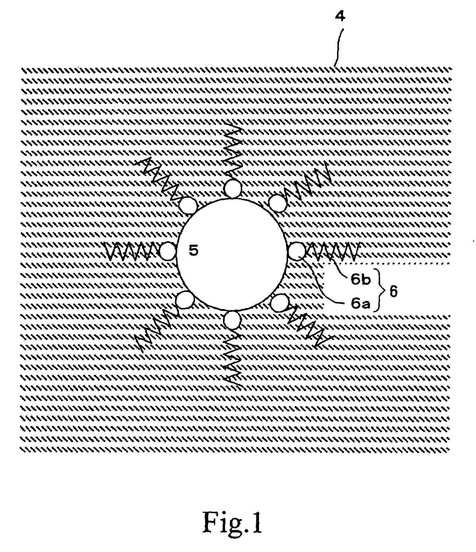

By adding the above-described surfactant material together with the above-described co-solvent or reactant to the supercritical fluid, as shown in Fig. 1, a reverse micelle is formed in a supercritical fluid 4 in such a way that the a strongly-hydrophilic, less-miscible co-solvent or reactant 5 is surrounded by hydrophilic groups 6a of surfactant materials 6, while directing the lipophilic groups (hydrophobic groups) 6b thereof outwardly, and this raises compatibility of the co-solvent or the reactant 5 in the non-polar supercritical fluid 4 such as that composed of carbon dioxide.

### BRIEF DESCRIPTION OF THE DRAWINGS

Fig. 1 is a drawing for explaining an example of supercritical fluid used for the surface treatment of the present invention;
Fig. 2 is a configuration drawing of one example of a treatment apparatus used for the surface treatment of the present invention;
Fig. 3 is a birds-eye view of an example of a micro electromechanical systems applied with the surface treatment of the present invention;
Figs. 4A to 4E are sectional views showing fabrication of a micro electromechanical systems applied with the surface treatment of the present invention;
Fig. 5 is a flow chart showing procedures of the surface treatment of the present invention;
Figs. 6A to 6C are sectional views showing process steps of fabrication of a semiconductor device applied with the surface treatment of the present invention; and
Figs. 7A and 7B are drawings showing a photomask applied with the surface treatment of the present invention.

### BEST MODES FOR CARRYING OUT THE INVENTION

The following paragraphs will describe minutely embodiments of the surface treatment method of the present invention referring to the attached drawings. In advance of description on the embodiments of the surf ace treatment method, a configuration of a treatment apparatus used for the surface treatment will be explained.

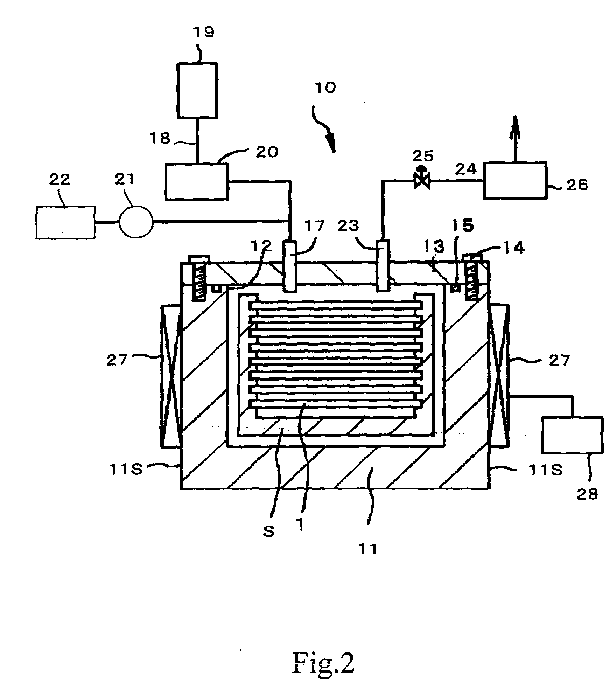

Fig. 2 is a configuration drawing of one example of a batch-type treatment apparatus used for the surface treatment of the present invention. A treatment apparatus 10 shown in this drawing comprises a treatment chamber 11 for housing therein a substrate 1 to be treated. The treatment chamber 11 houses a cassette S having a plurality of substrates 1 held therein, and has an opening 12 through which the cassette is loaded and unloaded. The opening 12 is provided with a lid 13 for tightly closing the inner space of the treatment chamber 11, the treatment chamber 11 and the lid 13 are fixed in close contact by tightening fixtures 14, and a sealing member 15 composed of an O ring is held between the treatment chamber 11 and the lid 13, so that the inner space of the treatment chamber 11 can be kept air-tight.

The treatment chamber 11 is further provided with a fluid supply port 17 typically in the lid 13 portion, and the fluid supply port 17 is connected through a supply tube 18 to a fluid supply source 19. From the fluid supply source 19, a substance capable of having a form of supercritical fluid (supercritical substance) is supplied typically in a gas form. The supply tube 18 is provided with a pressure/temperature control means 20 for controlling the supercritical substance supplied from the fluid supply source 19 so as to have a predetermined pressure and temperature. This makes it possible to introduce the supercritical substance conditioned to a predetermined pressure and temperature into the treatment chamber 11.

The supply tube 18 is further connected with a chemical supply source 22 while placing a flow control valve 21 in between, on the side more closer to the treatment chamber 11 as viewed from the pressure/temperature control means 20. This allows the apparatus to be configured so that fluids (co-solvent or reactant and surfactant) are added in a predetermined ratio to the supercritical substance supplied from the fluid supply source 19, and so that these fluids are supplied, together with the supercritical substance, from the supply port to the treatment chamber 11.

The treatment chamber 11 is further provided with a fluid discharge port 23 in a portion of the lid 13. To a pipe 24 connected to the fluid discharge port 23, a control valve 25 for discharging the fluid in the treatment chamber 11 is provided. The control valve 25 functions so as to open when the inner pressure of the treatment chamber 11 reaches a predetermined pressure or above, to thereby discharge the treatment fluid introduced into the treatment chamber 11. The control valve 25 is successful in keeping the pressure in the treatment chamber 11 constant.

On the downstream side of the control valve 25, a discharge fluid separation device 26 is connected. The discharge fluid separation device 26 recovers a medium separated in a liquid form (e.g., co-solvent or reactant and surfactant) as a drainage when the fluid discharged on the downstream side of the control valve 25 returns to the atmospheric pressure, and recovers components discharged in a gas form (e.g., supercritical substance) as an exhaust gas. The exhaust gas is recovered by a gas recovery unit, not shown. The recovered drainage and exhaust gas may also be recycled after converted into available forms.

On the side wall 11S of the treatment chamber 11, a heating means 27 for heating the supercritical substance introduced into the treatment chamber 11 and keeping it at a constant temperature is provided. The heating means 27 can be configured using a heating medium such as a heating wire. For the case where the heating medium is configured using a heating wire, it is preferable to provide a power source (not shown) for supplying electric power to the heating wire outside the treatment chamber 11, and to provide a temperature control device 28 for controlling temperature of the heating means 27 at a predetermined temperature through control of electric power to be supplied to the heating wire. It is to be understood that the paragraphs in the above described a batch-type treatment apparatus, but the apparatus may also be a single-slice treatment apparatus, which can reduce the space capacity of the treatment chamber although the throughput may degrade. Anyway the surface treatment using these treatment apparatuses will follow similar procedures as described in the next.

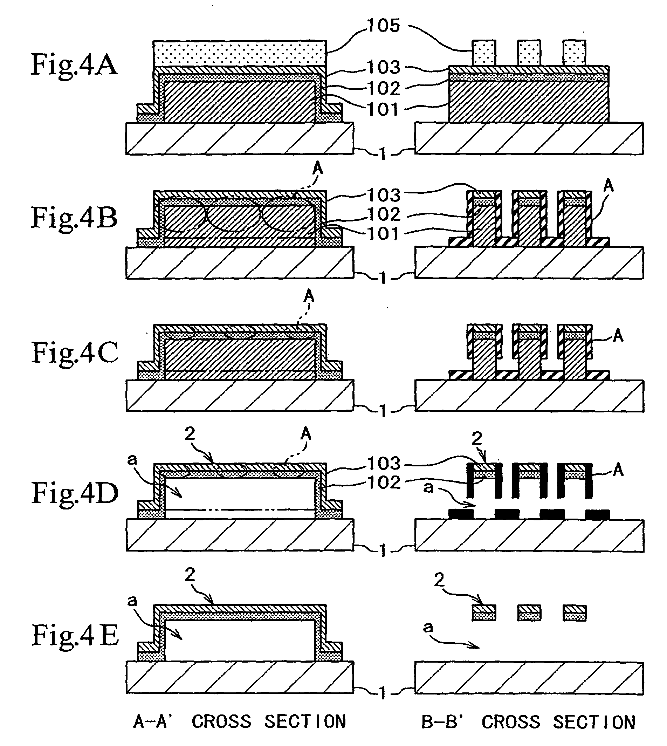

Next paragraphs will describe an embodiment of a method of fabricating micro electromechanical systems applied with the surface treatment method using the above-described treatment apparatus, referring to the attached drawings. A final structure obtained by the embodiment of the present invention is equivalent to that of the micro electromechanical systems as explained in the "BACKGROUND ART" referring to the birds-eye view of Fig. 3, having the structural body 2 as being spaced by the hollow portion "a" from the substrate 1. Fabrication of thus-configured micro electromechanical systems will be explained referring to Figs. 4A to 4E. It is to be noted that Figs. 4A to 4E correspond with sections taken along direction A-A' and direction B-B' in Fig. 3.

First, as shown in Fig. 4A, a sacrificial layer (first layer) 101 is patterned in a predetermined form (e.g., line form) on the substrate 1. The sacrificial layer 101 may be formed using any material so far as it can selectively be etched while leaving the substrate 1 and any structural layer formed on the sacrificial layer 101 in the next process step, and the material may typically be SiO₂ and PSG (phosphorus-doped glass) for the case where a Si substrate is used as the substrate 1, and may be polysilicon for the case where a SiO₂ substrate is used as the substrate 1.

Next, as the structural layer for forming the structural body, a second layer 102 and a third layer 103 are formed on the entire surface of the substrate 1. The third layer 103 is formed using a metal material, as being stacked on the second layer 102. The second layer 102 and third layer 103 may be composed of anymaterials so far as they allow selective etching of the sacrificial layer 101. Metal film, oxide film and semiconductor film are typically used depending on purposes of the structural body, where SiN layer andpoly-Si layer formed by the reduced-pressure CVD process are widely used in general for their desirable mechanical characteristics and easy process.

On thus-formed third layer 103, a resist pattern 105 is formed.

Thereafter, as shown in Fig. 4B, the third layer 103, the second layer 102 and the sacrificial layer 101 are patterned by etching using the resist pattern 105 as a mask. In this process, first the structural layer composed of the second layer 102 and the third layer 103 is formed in a beam form across the line-formed sacrificial layer 101, so as to be directly formed on the substrate 1 at both ends of the structural layer, or a portion intended for serving as a fixed portion, and so as to overlap the sacrificial layer 101 in the residual most portion, or a portion intended for serving as a mobile portion. The sacrificial layer 101 is thereafter etched.

In the etching process, an etching gas and materials composing the resist pattern 105, the second layer 102 and the third layer 103 react with each other, and resultant reaction products adhere as a residue "A" on the etched surface.

The resist pattern 105 is then removed, and as shown in Fig. 4C, the substrate 1 is subjected to aqueous cleaning in order to remove the residue "A". This successfully removes the most part of the residue "A", but the cleaning solution cannot fully be supplied to void portions and the bottom portions thereof having a narrow etching intervals, and this results in residue "A" remained in these portions.

After the above-described aqueous cleaning, as shown in Fig. 4D, the sacrificial layer 101 is selectively etched off while leaving the substrate 1, the second layer 102 and the third layer 103 unetched. The etching gas herein can reach the sacrificial layer 101 through the voids between the structural bodies 2, so that also the portions under the structural layer which is composed of the second layer 102 and third layer 103 can be removed. This results in formation of the structural body 2 as being spaced by the hollow portion "a" from the substrate 1, allowing the structural body 2 to freely vary the distance from the substrate 1. Thus-configured, beam-formed structural body 2 as being spaced by the hollow portion "a" from the substrate 1 is widely used for sensors, oscillators, micro-springs and optical elements.

After completion of all process steps, on the substrate having the structural body 2 with the hollow portion "a" formed thereon, the residue "A" which could not completely been removed in the process step in Fig. 4C remains in an intact form or in a less-removable form after being denatured by the dry etching or ion implantation. The substrate 1 has also residue "A" adhered thereon, which was newly produced in the etching shown in Fig. 4D.

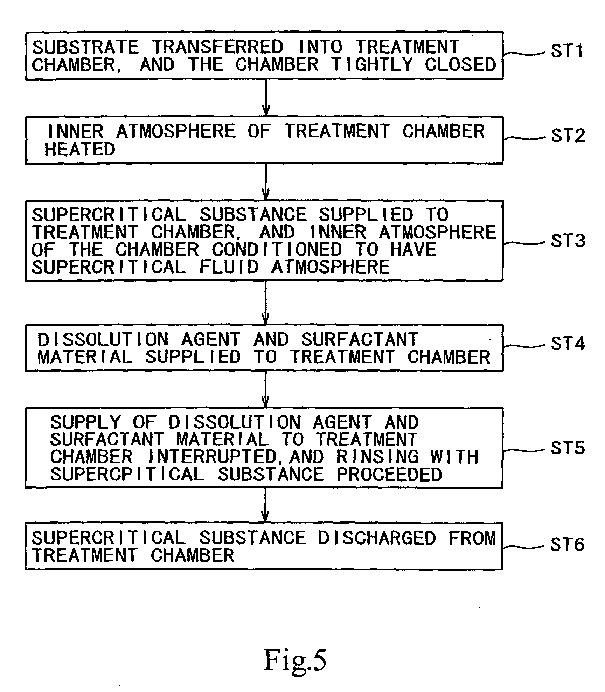

The surface of the substrate 1 having the structural body 2 with the hollow portion "a" formed thereon is cleaned using the supercritical fluid as shown in Fig. 4E. The surface treatment of the substrate 1 herein is carried out by using the treatment apparatus 10 configured as explained referring to Fig. 2, following the procedures shown by the flow chart in Fig. 5 (see Figs. 2 and 5, hereinafter).

First, as shown in a first step ST1, the cassette S having a plurality of substrates 1 to be cleaned (or dried) housed therein is housed in the treatment chamber 11 through the opening 12 thereof, and the lid 13 is closed to thereby make the treatment chamber 11 air-tight.

Next, as shown in a second step ST2, temperature of the inner atmosphere of the treatment chamber 11 is preliminarily heated to a temperature equal to or higher than the supercritical temperature of the supercritical substance using the heating means 27 and the temperature control device 28.

While keeping this state, next in the third step ST3, a predetermined supercritical substance is introduced into the treatment chamber 11 through adjustment by the pressure/temperature control means 20. The supercritical substance herein is supplied in a gas form from the fluid supply source 19, wherein it is important to adjust the pressure/temperature control means 20 of the supercritical substance introduced into the treatment chamber 11, and to adjust the pressure of the inner atmosphere of the treatment chamber 11 using the heating means 27 and temperature control device 28, so as to prevent the supercritical substance from liquefying in the treatment chamber 11, or in other words, so as to convert the supercritical substance directly from gas into the supercritical fluid. This is successful in filling the treatment chamber 11 with the supercritical fluid without exposing the surface of the substrate, having the structural bodies formed thereon, to the gas-liquid interface.

Therefore, for example, the supercritical substance (e.g., carbon dioxide) supplied in a gas form from the fluid supply source 19, which is kept as being heated to a temperature equal to or higher than the supercritical temperature through adjustment by the pressure/temperature control means 20, is introduced into the treatment chamber 11 initially kept at normal pressure. In this step, similarly to as set in the second step ST2, temperature of the inner atmosphere of the treatment chamber 11 is preliminarily raised to a temperature equal to or higher than the supercritical temperature of the supercritical substance.

The supercritical substance becomes the supercritical fluid when the pressure of the inner atmosphere of the treatment chamber 11 rises up to, or higher than the critical pressure of the supercritical substance while continuing supply of the supercritical substance into the treatment chamber 11 under adjustment of the temperature of the inner atmosphere of the treatment chamber 11 using the heating means 27 and the temperature control device 28 as described in the above. In an exemplary case where carbon dioxide is used as the supercritical substance, carbon dioxide becomes the supercritical fluid after being pressurized to a critical pressure of carbon dioxide of 7.38 MPa or above, and after being heated up to a critical temperature of carbon dioxide of 31.1°C or above.

Next in a fourth step ST4, the supercritical substance thus supplied to the treatment chamber 11 is added with a co-solvent or a reactant and further with a surfactant material supplied from the chemical supply source 22, under regulation by the flow control valve 21.

It is to be understood that the co-solvent or the reactant added herein may be any of ammonium hydroxide, alkanolamine, amine fluoride, hydrofluoric acid and so forth, which have been exemplified in the "DISCLOSURE OF THE INVENTION". The co-solvent or the reactant expressed by the specific examples may be added to the supercritical substance in a singularmanner or in any combination of a plurality of species. Assuming that the supercritical substance is carbon dioxide, the total amount of addition of the co-solvent or the reactant in proportion to the supercritical substance (supercritical fluid) of 40°C and 8 MPa is adjusted within a concentration range from 0.1 to 2 mol%, and more preferably 0.1 to 1 mol%. Concentration of the co-solvent or the reactant lower than the above concentration range will result in only an incomplete removal of the polymerized etching residue, and exceeding the above concentration range will result in an incomplete suppression of corrosion of any metal materials.

These co-solvents or reactants are generally higher in the critical temperature and critical pressure than the supercritical substance (e.g., carbon dioxide). In this case, the critical temperature and critical pressure of a mixed fluid of the supercritical substance and co-solvent or reactant becomes higher than those of the supercritical substance as a single entity. It is therefore preferable to keep the temperature and pressure of the inner atmosphere of the treatment chamber 11 typically as high as 40°C and 10 MPa or above, so that the co-solvent or the reactant can thoroughly dissolve into the supercritical substance.

Moreover, the surfactant material added herein is any of those described in the "DISCLOSURE OF THE INVENTION" in the above. Assuming that the supercritical substance is carbon dioxide, the total amount of addition of the surfactant in proportion to the supercritical substance of 40°C and 8 MPa is adjusted within a concentration range from 1 to 10 mol%, and more preferably 1 to 5 mol%. Concentration of the surfactant material lower than the above concentration range cannot allow the co-solvent or the reactant to fully dissolve into the supercritical fluid, and exceeding the above concentration range will result in phase separation of the surfactant material. Therefore the concentration of the surfactant material out of the above-described concentration range will result in only a small cleaning effect and an incomplete cleaning effect of deposited polymer.

The above efforts allow the supercritical fluid to be supplied to the treatment chamber 11, while being added with the co-solvent or the reactant under a condition of having a raised compatibility with the aid of the surfactant material. By continuing the supply of this type of supercritical fluid, the inner space of the treatment chamber 11 is filled with the supercritical fluid, and after the inner pressure of the treatment chamber 11 reaches a predetermined pressure, the control valve 25 opens to keep the inner atmosphere of the treatment chamber 11 at a predetermined pressure. The gas in the treatment chamber 11 is thus completely replaced with the supercritical fluid.

Under the condition in which the inner atmosphere of the treatment chamber 11 is completely replaced with the supercritical fluid, the substrate is treated at a predetermined temperature only for a predetermined duration of time, to thereby remove the residue and fine particles on the surface of the substrate 1. The foreign matters removed from the surface of the substrate 1 are discharged together with the supercritical fluid through the fluid discharge port 23 out from the treatment chamber 11.

After the above-described processes are completed and thereby the foreign matters such as the residue and fine particles are removed from the surface of the substrate 1, the supply of the co-solvent or the reactant and surfactant material from the chemical supply source 22 is terminated in a fifth step ST5, and only the supercritical substance (e.g., carbon dioxide) is supplied to the treatment chamber 11, to thereby replace the supercritical fluid added with the co-solvent or the reactant (and surfactant material) with the supercritical fluid not added with any co-solvent or any reactant and so forth. This completes rinsing of the surface of the substrate 1.

Thereafter in a sixth step ST6, the supply of the supercritical substance from the fluid supply source 19 is terminated, the supercritical fluid in the treatment chamber 11 is discharged through the fluid discharge port 23 to thereby lower the temperature and pressure of the inner atmosphere of the treatment chamber 11, and convert the supercritical substance remained in the treatment chamber 11 into a gas form. This allows the treatment chamber 11 to be filled with the gaseous supercritical substance (carbon dioxide) and to proceed drying (i.e., supercritical drying) of the substrate 1 housed therein.

In the supercritical drying, it is important to lower the temperature and pressure of the inner atmosphere of the treatment chamber 11, so as to prevent the supercritical substance in the state of supercritical fluid from liquefying in the treatment chamber 11, or in other words, so as to convert it directly from the supercritical fluid into gas. This is successful in filling the treatment chamber 11 with the supercritical fluid without exposing the surface of the substrate, having the structural bodies formed thereon, to the gas-liquid interface.

Therefore in an exemplary case where carbon dioxide is used as the supercritical substance, the inner atmosphere of the treatment chamber 11, which is conditioned at 31.1°C or above and 7.38 MPa or above so as to keep the contained carbon dioxide in the supercritical fluid state, is reduced only in the pressure to the atmospheric pressure while keeping the temperature at 31.1°C or above, to thereby convert the carbon dioxide from the supercritical fluid state to gas state. Thereafter, the temperature of the inner atmosphere of the treatment chamber 11 is lowered from 31.1°C or above to room temperature (e.g., 20°C) . This makes carbon dioxide in the treatment chamber 11 change from the supercritical fluid directly into gas without going through the liquid state, and brings the treatment chamber 11 into a dry state. For the case where any supercritical substances other than carbon dioxide are used as the supercritical fluid, it is allowable to carry out the cleaning and drying under pressure and temperature adapted to the individual substances to be used.

In the above treatment, the fluid in the treatment chamber 11 discharged through the fluid discharge port 23 is discharged out of the system via the discharge fluid separation device 26. In this process, a medium separated in a liquid form (e.g., co-solvent or reactant and surfactant) when the discharged fluid returns to the atmospheric pressure is recovered as a drainage. On the other hand, any components discharged in a gas form (e.g., carbon dioxide as the supercritical substance) is recovered as an exhaust gas. The recovered drainage and exhaust gas may also be recycled after converted into available forms.

As has been described in the above, the surface treatment using the supercritical fluid successfully removes, as shown in Fig. 4E, the residue on the surface of the substrate 1 having the structural bodies 2 with the hollow portions "a" formed thereon.

According to the above-described surface treatment method, addition of the co-solvent or the reactant such as ammonium hydroxide, alkanolamine, amine fluoride or hydrofluoric acid to the supercritical fluid which is excellent in permeability makes it possible to supply the co-solvent or the reactant, together with the supercritical fluid, into the voids of fine structural bodies on the surface of the substrate. The co-solvent or the reactant has a cleaning ability by which photoresist remained after etching or polymerized etching residue (simply referred to as residue, hereinafter) can be dissolved off. This results in an improved cleaning power of the supercritical fluid with respect to the surface of the substrate after the structural bodies are formed thereon by etching. Moreover, thus removed residue can readily be taken and washed away together with the chemical solution and supercritical fluid from the gap between the structural bodies, because the supercritical fluidhas a larger density than gas has. This consequently makes it possible to completely remove the residue in the voids of the fine structural bodies, without relying upon the aqueous cleaning.

Because only the treatment using the supercritical fluid is carried out without using any liquid, it is made possible to prevent the structural bodies 2 from being destroyed due to the surface tension at the gas-liquid interface, by carrying out the process while adjusting the temperature and pressure of the inner atmosphere of the treatment chamber 11 so that the surface of the substrate having the structural bodies formed thereon will not pass through the gas-liquid interface. This consequently results in an improved yield ratio of fabrication of micro electromechanical systems.

Because only the treatment using the supercritical fluid is carried out without using any liquid, it is alsomade possible for the surface of the substrate having the structural bodies formed thereon not to pass through the gas-liquid interface as described in the above, only by adjusting the temperature and pressure of the supercritical substance. It is therefore possible to reduce the number of process steps in the surface treatment as compared with a method in which the supercritical drying comes after the wet treatment.

The foregoing paragraphs have explained an embodiment in which the present invention was applied to the process of fabricating a fine movable element called micro electromechanical systems. The present invention is, however, not limitative to be applied to this sort of surface treatment in the process of fabricating micro electromechanical systems, and is widely applicable to cleaning of the surface having fine structural bodies formed thereon, from which similar effects can be obtained.

For example, in formation of large-scale integrated circuits of semiconductor devices, the method is similarly applicable to surface treatment after high-aspect-ratio patterns (including electrodes, wiring patterns and resist patterns) are formed, or to surface treatment after high-aspect-ratio patterns, used for forming these patterns, are formed in formation process of masks used for electron beam lithography or X-ray lithography are formed.

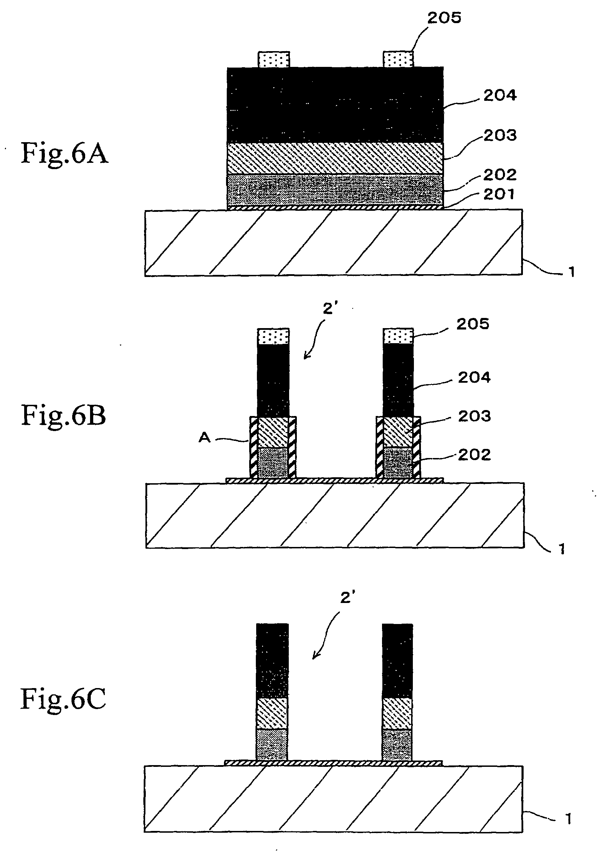

As an example of formation of this sort of high-aspect-ratio pattern, Figs. 6A to 6C show sectional views of process steps of forming electrodes in fabrication of a semiconductor device. The following paragraphs will describe an embodiment of the surface treatment of the present invention in the process of forming high-aspect-ratio electrodes (structural bodies) on the substrate 1.

First, as shown in Fig. 6A, a thin insulating film is formed as a first layer 201 on the substrate 1 composed of single crystal Si, and thereafter a second layer 202, a third layer 203 and a fourth layer 204 are stacked. It is specifically noted that the third layer 203 is composed of a metal material. Next a resist pattern 205 is formed on the fourth layer 204.

Next, as shown in Fig. 6B, the fourth layer 204, third layer 203 and second layer 202 are sequentially dry-etched through the resist pattern 205 as a mask, to thereby form fine high-aspect-ratio electrodes 2' on the substrate 1. After completion of the dry etching, the etching residue "A" are formed on the side faces of the second layer 202 and third layer 203.

Then as shown in Fig. 6C, the surface treatment for cleaning the surface of the substrate 1 having the electrodes 2' formed thereon is carried out. The surface treatment is carried out similarly to as described in the above referring to Fig. 5, Fig. 2 and Fig. 4E in the aforementioned fabrication of micro electromechanical systems, according to the method in which the co-solvent or the reactant (or additional surfactant material) was added to the supercritical fluid.

This makes it possible to remove the etching residue "A" and other foreign matters remain between the electrodes 2' , without causing collapse of the high-aspect-ratio electrodes 2' .

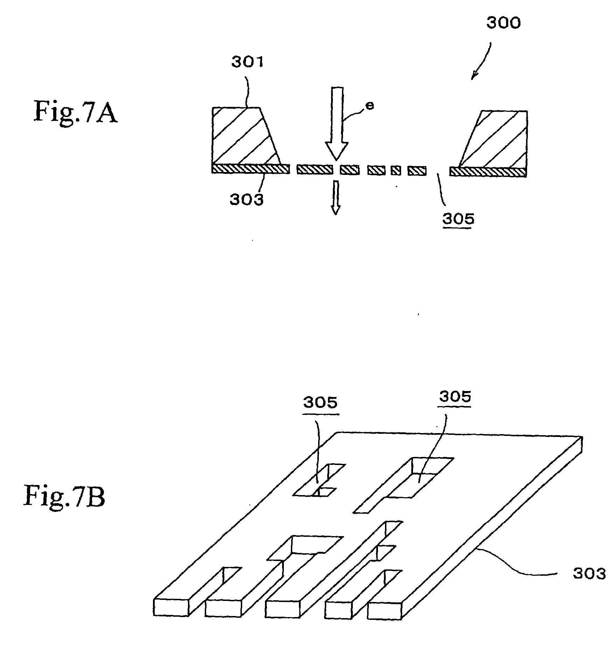

Besides this, the photomask for electron beam lithography and X-ray lithography shown in the above as exemplary formation processes of high-aspect-ratio patterns includes a stencil mask used for LEEPL (Low Energy E-beam Proximity Projection Lithography) typically as shown in Figs. 7A and 7B. Fig. 7A is a sectional view of the photomask (stencil mask) , and Fig. 7B is a perspective view showing an essential portion of the photomask.

The photomask (stencil mask) 300 shown in these drawings is configured so that a thin film (membrane), having an opening-formed pattern 305 formed therein, is stretched over one side of the support frame 301, and is shaped by allowing electron beam "e" used as an exposure light to pass through the pattern 305. This sort of photomask 300 has been suffering from difficulty in the surface treatment of the thin film 303, whereas the surface treatment of the present invention makes it possible to remove the etching residue or other foreign matters remaining in the pattern 305, without exerting impact on the substrate in a form of the thin film 303.

The present invention is also not limitative to the surface treatment of the above-described stencil mask, and makes it possible to carry out a surface treatment typically in which, for example, etching residue and other foreign matters are removed from a membrane mask (photomask) which comprises a thin film (membrane) and a light interception pattern formed thereon, without exerting any impact on the substrate as the thin film and on the high-aspect-ratio light interception pattern formed thereon.

Besides the above-described LEEPL, there are other types of electron beam lithography such as PREVAIL (Projection Exposure with Variable Axis Immersion Lenses) and SCALPEL (scattering with angular limitation in projection electron-beam lithography), for any of these techniques the surface treatment of the photomask is still difficult at present. The present invention is applicable to this sort of surface treatment of the photomask and can yield the similar effects.

Although the foregoing embodiments explained the case where the co-solvent or the reactant and surfactant are added to the supercritical fluid, it is also effective, if necessary, to add an anticorrosive adapted to wiring metal to be used, besides the co-solvent or the reactant. It is to be understood that, for the case where a supercritical substance other than carbon dioxide is used as a supercritical substance capable of having a form of supercritical fluid, the treatment should be carried out under conditions (temperature, pressure, and amount of addition of co-solvent or reactant and surfactant) which are set so as to be suited for the materials to be used.

### INDUSTRIAL APPLICABILITY

According to the surface treatment method of the present invention, it is made possible to thoroughly remove etching residue remaining in voids of fine structural bodies, only by a treatment using a supercritical fluid through addition of a co-solvent or a reactant for the etching residue to the supercritical fluid. This makes it no more necessary to carry out aqueous cleaning whichmainly relies upon chemical solution, and succeeding drying, and instead makes it possible to carry out cleaning and drying within the same chamber, and therefore makes it possible to carry out the surface treatment (cleaning) while preventing any increase in the number of process steps and any destruction of the structural bodies.

As a consequence, it is made possible to attain quality assurance, improvement in the yield ratio and reduction in the production cost of semiconductor devices and micro electromechanical systems having fine structural bodies on the surface thereof.

The treatment apparatus of the present invention makes it possible to carry out the above-described surface treatment of the present invention.

## Claims

1. A surface treatment method **characterized by** treating a surface with a supercritical fluid, wherein
an ammonium hydroxide expressed by the formula (1) below is added as a co-solvent or a reactant to said supercritical fluid: 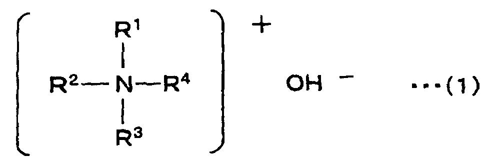 where each of R¹ to R⁴ in the formula (1) independently denotes an alkyl group, hydroxy-substituted alkyl group, aryl group or hydrogen.

2. A surface treatment method according to claim 1, wherein said surface has a structural body thereon.

3. A surface treatment method according to claim 2, wherein said structural body is a fine structural body with a hollow portion, a micromachine, or an electrode pattern.

4. A surface treatment method according to claim 2, wherein said surface is that of a photomask utilized for lithography.

5. A surface treatment method according to claim 1, wherein said supercritical fluid is carbon dioxide.

6. A surface treatment method according to claim 1, wherein said supercritical fluid is further added with a surfactant material.

7. A surface treatment method according to claim 6, wherein said surfactant material is a polar solvent.

8. A surface treatment method **characterized by** treating a surface with a supercritical fluid, wherein
an alkanolamine expressed by the formula (2) below is added as a co-solvent or a reactant to said supercritical fluid:
R¹R²-N-CH₂CH₂-O-R³ (2)
where each of R¹ to R³ in formula (2) independently denotes an alkyl group, hydroxy-substituted alkyl group, aryl group or hydrogen.

9. A surface treatment method according to claim 8, wherein said surface has a structural body thereon.

10. A surface treatment method according to claim 9, wherein said structural body is a fine structural body with a hollow portion, a micromachine, or an electrode pattern.

11. A surface treatment method according to claim 9, wherein said surface is that of a photomask utilized for lithography.

12. A surface treatment method according to claim 8, wherein said supercritical fluid is carbon dioxide.

13. A surface treatment method according to claim 8, wherein said supercritical fluid is further added with a surfactant material.

14. A surface treatment method according to claim 13, wherein said surfactant material is a polar solvent.

15. A surface treatment method **characterized by** treating a surface with a supercritical fluid, wherein
an amine fluoride expressed by the formula (3) below is added as a co-solvent or a reactant to said supercritical fluid: 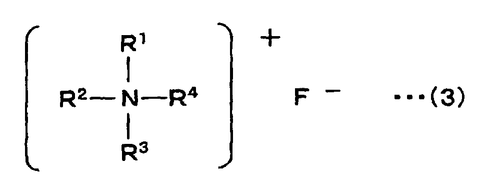 where each of R¹ to R⁴ in the formula (3) independently denotes an alkyl group, hydroxy-substituted alkyl group, aryl group or hydrogen.

16. A surface treatment method according to claim 15, wherein said surface has a structural body thereon.

17. A surface treatment method according to claim 16, wherein said structural body is a fine structural body with a hollow portion, a micromachine, or an electrode pattern.

18. A surface treatment method according to claim 16, wherein said surface is that of a photomask utilized for lithography.

19. A surface treatment method according to claim 15, wherein said supercritical fluid is carbon dioxide.

20. A surface treatment method according to claim 16, wherein said supercritical fluid is further added with a surfactant material.

21. A surface treatment method according to claim 20, wherein said surfactant material is a polar solvent.

22. A surface treatment method **characterized by** treating a surface with a supercritical fluid, wherein
hydrofluoric acid is added as a co-solvent or a reactant to said supercritical fluid.

23. A surface treatment method according to claim 22, wherein said surface has a structural body thereon.

24. A surface treatment method according to claim 23, wherein said structural body is a fine structural body with a hollow portion, a micromachine, or an electrode pattern.

25. A surface treatment method according to claim 23, wherein said surface is that of a photomask utilized for lithography.

26. A surface treatment method according to claim 22, wherein said supercritical fluid is carbon dioxide.

27. A surface treatment method according to claim 22, wherein said supercritical fluid is further added with a surfactant material.

28. A surface treatment method according to claim 27, wherein said surfactant material is a polar solvent.

29. A semiconductor device obtainable by a surface treatment method **characterized by** treating a surface with a supercritical fluid, wherein
an ammonium hydroxide expressed by the formula (1) below is added as a co-solvent or a reactant to said supercritical fluid: 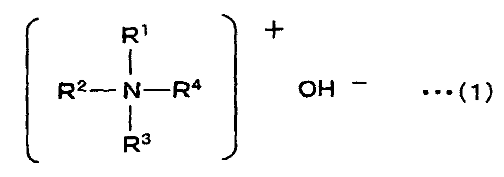 where each of R¹ to R⁴ in the formula (1) independently denotes an alkyl group, hydroxy-substituted alkyl group, aryl group or hydrogen.

30. A semiconductor device obtainable by a surface treatment method **characterized by** treating a surface with a supercritical fluid, wherein
an alkanolamine expressed by the formula (2) below is added as a co-solvent or a reactant to said supercritical fluid:
R¹R²-N-CH₂CH₂-O-R³ (2)
where each of R¹ to R³ in formula (2) independently denotes an alkyl group, hydroxy-substituted alkyl group, aryl group or hydrogen.

31. A semiconductor device obtainable by a surface treatment method **characterized by** treating a surface with a supercritical fluid, wherein
an amine fluoride expressed by the formula (3) below is added as a co-solvent or a reactant to said supercritical fluid: 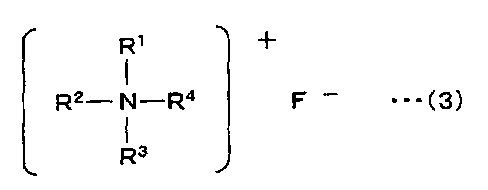 where each of R¹ to R⁴ in the formula (3) independently denotes an alkyl group, hydroxy-substituted alkyl group, aryl group or hydrogen.

32. A semiconductor device obtainable by a surface treatment method **characterized by** treating a surface with a supercritical fluid, wherein
hydrofluoric acid is added as a co-solvent or a reactant to said supercritical fluid.

33. A method of fabricating a semiconductor device, said method comprising;
adding an ammonium hydroxide expressed by the formula (1) below as a co-solvent or a reactant to a supercritical fluid, and
treating a surface of said semiconductor device with said supercritical fluid: 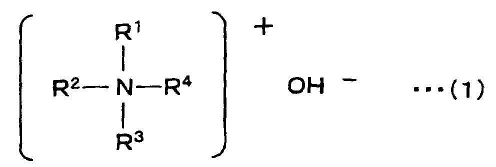 where each of R¹ to R⁴ in the formula (1) independently denotes an alkyl group, hydroxy-substituted alkyl group, aryl group or hydrogen.

34. A method of fabricating a semiconductor device, said method comprising;
adding an alkanolamine expressed by the formula (2) below as a co-solvent or a reactant to a supercritical fluid, and
treating a surface of said semiconductor device with said supercritical fluid:
R¹R²-N-CH₂CH₂-O-R³ (2)
where each of R¹ to R³ in formula (2) independently denotes an alkyl group, hydroxy-substituted alkyl group, aryl group or hydrogen.

35. A method of fabricating a semiconductor device, said method comprising;
adding an amine fluoride expressed by the formula (3) below as a co-solvent or a reactant to a supercritical fluid, and
treating a surface of said semiconductor device with said supercritical fluid: 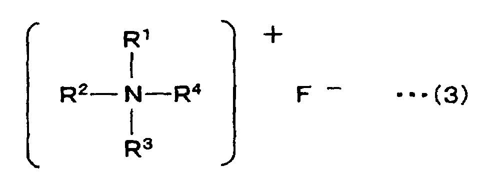 where each of R¹ to R⁴ in the formula (3) independently denotes an alkyl group, hydroxy-substituted alkyl group, aryl group or hydrogen.

36. A method of fabricating a semiconductor device, said method comprising;
adding hydrofluoric acid as a co-solvent or a reactant to a supercritical fluid, and
treating a surface of said semiconductor device with said supercritical fluid.

37. A treatment apparatus comprising;
a treatment chamber for housing therein a substrate to be treated,
an opening through which said substrate is loaded and unloaded,
a lid provided with said opening for tightly closing the inner space of said treatment chamber,
a sealing member held between said treatment chamber and said lid, so that the inner space of said treatment chamber can be kept air-tight,
a fluid supply port provided with said treatment chamber, and
a fluid supply source connected to said fluid supply port, supplying a substance capable of having a form of supercritical fluid.

38. A treatment apparatus according to claim 37, wherein;
said fluid supply source is capable of supplying said substance capable of having a form of supercritical fluid in a gas form.

39. A treatment apparatus according to claim 37, further comprising;
a valve for discharging said substance capable of having a form of supercritical fluid in said treatment chamber.

40. A treatment apparatus according to claim 39, further comprising;
a discharge fluid separation device connected to said valve.

41. A treatment apparatus according to claim 40, further comprising;
a heating means provided with said treating chamber for heating said supercritical substance.
